# FASCICULE DE BREVET EUROPEEN

(11) **EP 2 516 506 B1**
(45) Date de publication et mention de la délivrance du brevet: **11.12.2013**
(21) Numéro de dépôt: 10810855.6
(22) Date de dépôt: 21.12.2010
(51) Int. Cl.: C08G 69/36, C08L 77/02, C08L 77/06, C08L 77/00, C08G 69/04, C08G 69/28, H05K 3/34, H05K 3/30

(54) **POLYAMIDE SEMI-AROMATIQUE, SON PROCEDE DE PREPARATION, COMPOSITION COMPRENANT UN TEL POLYAMIDE ET LEURS UTILISATIONS.**
HALBAROMATISCHES POLYAMID, VEFAHREN ZUR HERSTELLUNG, ZUSAMMENSETZUNG MIT EINEM DERARTIGEN POLYAMID UND VERWENDUNG
SEMIAROMATIC POLYAMIDE, PROCESS FOR PREPARING SAME, COMPOSITION COMPRISING SUCH A POLYAMIDE AND USES THEREOF

(30) Priorité: 24.12.2009 FR 0959598
(43) Date de publication de la demande: 31.10.2012
(73) Titulaire: Arkema France, 92700 Colombes (FR)
(72) Inventeur: BRIFFAUD, Thierry, F-27300 Caorches Saint Nicolas (FR); FERREIRO, Vincent, F-63430 PONT du CHATEAU (FR)
(74) Mandataire: Delprat, Corinne
(86) Numéro de dépôt international: PCT/FR2010/052840
(87) Numéro de publication internationale: WO 2011/077032

(56) Documents cités:
- EP-A1- 0 725 100
- EP-A1- 0 885 930
- GB-A- 2 006 797
- US-A- 4 225 701
- US-A- 5 416 172
- US-A- 5 418 068
- US-A1- 2004 077 769
- "GRILAMID TR - A transparent polyamide with unlimited possibilities", INTERNET CITATION, décembre 2003 (2003-12), pages 1-36, XP002541395, Extrait de l'Internet: URL:http://www.mess-regeltechnik.at/LICO/G rilamed_prospekt_4007_e.pdf [extrait le 2009-08-04]

## Description

### [Domaine de l'invention]

La présente invention a pour objet un polyamide semi-aromatique, son procédé de préparation ainsi que ses utilisations, notamment dans la fabrication d'objets divers, comme des composants électroniques destinés à des équipements électriques ou électroniques dans le domaine des transports routiers, de la circulation routière ou ferroviaire, dans le domaine aéronautique, audio-vidéo, des jeux vidéo et également dans le secteur industriel.

L'invention se rapporte également à une composition comprenant un tel polyamide semi-aromatique ainsi qu'aux utilisations de cette composition, notamment dans la fabrication de tout ou partie des composants électroniques utilisables dans les secteurs qui viennent d'être énumérés ci-dessus.

### [L'art antérieur et le problème technique]

Actuellement, dans le domaine de l'électronique, la fabrication des circuits électroniques recourt de plus en plus à la technologie dite des éléments installés en surface ou surface-mount technology (SMT). Cette technologie permet de disposer les composants électroniques, de taille réduite, directement sur une carte de circuit imprimé, préalablement recouverte d'une composition de brasage. Ces composants électroniques peuvent notamment être des connecteurs, des commutateurs ou encore des réflecteurs à diode électroluminescente (Light Emitting Diode ou LED).

La soudure de tels composants électroniques sur la carte de circuit imprimé, qui se fait par l'intermédiaire de la composition de brasage, est réalisée par le passage de l'ensemble dans un four à fusion.

Ces compositions de brasage sont le plus souvent à base de polymères thermoplastiques. De tels polymères doivent bien évidemment être choisis de manière à résister aux températures élevées des fours à fusion mais également de manière à ne pas laisser apparaître de déformation des circuits électroniques. Il faut en particulier rechercher des polymères qui permettent d'éviter le phénomène de "blistering", c'est-à-dire la formation de cloquages, au niveau de la surface de ces circuits électroniques.

Parmi les polymères thermoplastiques susceptibles d'être utilisés dans la mise en oeuvre de cette technologie SMT, le document US 2004/0077769 décrit une composition à base de polyamide comprenant :
- de 20 à 80% en poids d'un polyamide ou d'un mélange de polyamides ayant une température de fusion supérieure à 280 °C,
- de 5 à 60% en poids d'au moins une charge ou un renfort,
- de 5 à 35% en poids d'au moins un agent ignifugeant, et
- de 1 à 10% en poids d'au moins un activateur d'ignifugation.

Le polyamide selon le document US 2004/0077769 comprend des unités répétitives dérivant :
(i) de l'acide téréphtalique ou d'un de ses dérivés et, de manière optionnelle, d'un ou plusieurs autres diacides aromatiques ou aliphatiques ou de leurs dérivés,
(ii) d'une ou plusieurs diamines aliphatiques ayant de 10 à 20 atomes de carbone et, de manière optionnelle, d'une ou plusieurs diamines additionnelles,
(iii) et, de manière optionnelle, d'un ou plusieurs acides aminocarboxyliques et/ou de lactames,
dans lequel l'acide téréphtalique comprend de 75 à 100% en moles de (i), la ou les diamines aliphatiques ayant de 10 à 20 atomes de carbone comprend(nent) de 75 à 100% en moles de (ii), et le ou les acides aminocarboxyliques ou de lactames comprend(nent) de 0 à 25% en moles de (iii) par rapport à la quantité totale (i)+(ii)+(iii).

De tels polyamides, dits polyamides semi-aromatiques en raison de la présence d'au moins un noyau aromatique dans l'un des motifs des dits polyamides, permettent effectivement d'atteindre des températures de fusion supérieures à 280°C. Un exemple de composition comprenant un polyamide semi-aromatique de formule 10.12/10.T, dans un rapport molaire de 10/90, présente même une température de fusion de 300 °C.

De tels polyamides semi-aromatiques se révèlent satisfaisants non seulement du point de vue des valeurs de températures de fusion qui peuvent être atteintes (supérieures à 280 °C), mais également en raison de la faible reprise d'humidité qui caractérise ces produits.

Ces polyamides semi-aromatiques sont décrits, en particulier dans le document WO 2006/135841, comme pouvant par ailleurs entrer dans des compositions permettant de fabriquer l'élément réfléchissant la lumière générée par une diode électroluminescente (LED).

Toutefois, si les valeurs des températures de fusion et de reprise d'humidité qui caractérisent les polyamides semi-aromatiques décrits dans les documents US 2004/0077769 et WO 2006/135841 sont compatibles avec la mise en oeuvre de la technologie SMT, en particulier pour le montage des connecteurs, commutateurs ou réflecteurs LED, la Demanderesse a constaté que, parmi tous ces polyamides, bon nombre d'entre eux, parmi lesquels ceux qui sont exemplifiés, ne répondent pas à un autre critère essentiel qui est la tenue à la thermo-oxydation.

Il y a donc un besoin réel permettant de trouver des polyamides semi-aromatiques, qui peuvent être utilisés pour la production de pièces de précision dans le domaine des connecteurs, des commutateurs et des réflecteurs à diode électroluminescente (LED), de tels polyamides présentant simultanément :
- une bonne tenue thermomécanique, avec des températures de fusion ou de fléchissement sous contrainte (Heat Distortion Temperature ou "HDT" mesurée selon la norme ISO 75) d'au moins 220°C, avantageusement d'au moins 275°C et, en particulier, sous une charge de 0,45 MPa,
- une très faible reprise en eau, avec des valeurs typiquement inférieures à 3%, voire 2,5%, pour éviter les phénomènes de "blistering" ou cloquage, et
- une bonne tenue à la thermo-oxydation, permettant ainsi à la fois de conserver de très bonnes propriétés mécaniques et de limiter le phénomène de jaunissement.

### [Brève description de l'invention]

La Demanderesse a trouvé que ces besoins sont conjointement atteints avec un polyamide semi-aromatique constitué :
- de 70 à 95% en moles d'un premier motif répétitif (A) obtenu à partir de la polycondensation d'au moins une diamine aliphatique linéaire comprenant de 9 à 36 atomes de carbone, avantageusement de 10 à 36 atomes de carbone, et d'au moins un acide dicarboxylique aromatique, et
- de 5 à 30% en moles d'un second motif répétitif (B) obtenu à partir d'au moins un lactame comprenant de 9 à 12 atomes de carbone et/ou d'au moins un acide aminocarboxylique comprenant de 9 à 12 atomes de carbone.

L'invention porte donc sur un polyamide semi-aromatique constitué d'au moins deux motifs répétitifs distincts, un premier motif répétitif (A) et un second motif répétitif (B), chacun de ces motifs étant obtenu à partir d'une sélection particulière de co-monomères.

La présente invention a également pour objet le procédé de préparation du dit polyamide semi-aromatique.

La présente invention a également pour objet une composition comprenant au moins un polyamide semi-aromatique selon l'invention.

La présente invention a enfin pour objet l'utilisation du polyamide semi-aromatique et de la composition selon l'invention pour constituer une structure monocouche ou multicouche. Plus préférentiellement, l'utilisation sera envisagée pour la fabrication de pièces injectées, telles que connecteurs, commutateurs, réflecteurs LED ou autres supports de composants électriques et/ou électroniques, qui pourront notamment être fabriquées par la mise en oeuvre de la technologie SMT.

### [Description détaillée de l'invention]

D'autres caractéristiques, aspects, objets et avantages de la présente invention apparaîtront encore plus clairement à la lecture de la description qui suit.

La nomenclature utilisée pour définir les polyamides est décrite dans la norme ISO 1874-1:1992 *"Plastiques - Matériaux polyamides (PA) pour moulage et extrusion - Partie 1 : Désignation",* notamment en page 3 (tableaux 1 et 2) et est bien connue de l'homme du métier.

Par ailleurs, il est précisé que l'expression "compris(e) entre" utilisée dans la suite de cette description doit s'entendre comme incluant les bornes citées.

Selon un premier aspect de l'invention, l'invention porte sur polyamide semi-aromatique constitué :
- de 70 à 95% en moles d'un premier motif répétitif (A) obtenu à partir de la polycondensation d'au moins une diamine aliphatique linéaire comprenant de 9 à 36 atomes de carbone, avantageusement de 10 à 36 atomes de carbone, et d'au moins un acide dicarboxylique aromatique, et
- de 5 à 30% en moles d'un second motif répétitif (B) obtenu à partir d'au moins un lactame comprenant de 9 à 12 atomes de carbone et/ou d'au moins un acide aminocarboxylique comprenant de 9 à 12 atomes de carbone.

Le second motif répétitif (B) est obtenu à partir :
- soit d'un lactame,
- soit d'un acide aminocarboxylique,
- soit d'un mélange de 2, ou plus, des composés qui viennent d'être cités.

Ce choix de second motif répétitif (B) permet d'obtenir un polyamide présentant un taux de cristallinité plus élevé qu'un polyamide semi-aromatique dont le second motif répétitif proviendrait de la condensation d'une diamine avec un acide dicarboxylique, le premier motif répétitif (A) étant par ailleurs identique pour ces deux polyamides semi-cristallins.

Ce choix particulier de second motif répétitif (B) permet également d'améliorer la résistance à la thermo-oxydation, comme le montrent les valeurs figurant dans le Tableau 1 ci-dessous, dans lequel :
- l'homopolyamide ou motif "6.10" correspond au produit de condensation de la 1,6-hexanediamine et de l'acide décanedioïque; ce motif possède, en moyenne, 8 atomes de carbone ;
- l'homopolyamide ou motif "6.12" correspond au produit de condensation de la 1,6-hexanediamine et de l'acide dodécanedioïque ; ce motif possède, en moyenne, 9 atomes de carbone ;
- l'homopolyamide ou motif "6.14" correspond au produit de condensation de la 1,6-hexanediamine et de l'acide tétradécanedioïque ; ce motif possède, en moyenne, 10 atomes de carbone ;
- l'homopolyamide ou motif "10.10" correspond au produit de condensation de la 1,10-décanediamine et de l'acide décanedioïque ; ce motif possède, en moyenne, 10 atomes de carbone ;
- l'homopolyamide ou motif "10.12" correspond au produit de condensation de la 1,10-décanediamine et de l'acide dodécanedioïque ; ce motif possède, en moyenne, 11 atomes de carbone ;
- l'homopolyamide ou motif "11" correspond au motif obtenu à partir de l'acide amino-11-undécanoïque et possède en moyenne 11 atomes de carbone.

Pour évaluer cette résistance à la thermo-oxydation, des tests de vieillissement oxydatif dans l'air chaud ont été conduits sur des tubes réalisés à partir de chacune des compositions permettant d'obtenir les différents motifs listés ci-dessus. Ces tubes présentent tous un diamètre externe de 8 mm avec un diamètre interne de 6 mm, c'est-à-dire qu'ils sont d'une épaisseur de 1 mm.

Les différents tubes ont été mis à vieillir dans l'air à 150 °C, puis ont été choqués avec un choc selon la norme DIN 73378, ce choc étant réalisé à température ambiante (23 °C) et à -40 °C. Sont reportés dans le Tableau 1 ci-dessous, les demi-vies (en heures) relevées qui correspondent au temps au bout duquel 50% des tubes testés se cassent.

**Tableau 1**

| Motif | 23 °C | -40 °C |
|---|---|---|
| 6.10 | 100 | 0 |
| 6.12 | 150 | 0 |
| 6.14 | 200 | 65 |
| 10.10 | 200 | 70 |
| 10.12 | 250 | 100 |
| 11 | 350 | 200 |

On observe donc que les valeurs de thermo-oxydation des homopolyamides provenant de la polycondensation d'une diamine avec un acide dicarboxylique sont bien moins bonnes que celle d'un homopolyamide provenant de la polycondensation d'un acide aminocarboxylique, en particulier à nombre d'atomes de carbone équivalent (voir les valeurs relevées pour les motifs "10.12" et "11", que ce soit à 23 °C ou à -40 °C).

Ce constat reste transposable à la synthèse des polyamides semi-aromatiques comprenant au moins deux motifs répétitifs distincts, également appelés "copolyamides".

De manière surprenante, la Demanderesse a constaté qu'en plus de leurs excellentes propriétés thermomécaniques, de faible reprise en eau et de bonne résistance à la thermo-oxydation, le polyamide semi-aromatique selon l'invention présente une bonne résistance aux rayons UV. Cette dernière propriété confère un double avantage, celui de permettre de fabriquer des objets qui ne présentent pas ou très peu de jaunissement au cours du temps, de tels objets ayant en outre des propriétés de réflectance qui ne s'altèrent pas non plus au cours du temps.

De telles propriétés sont particulièrement intéressantes pour la fabrication de pièces telles que des réflecteurs à diode électroluminescente (Light Emitting Diode ou LED).

A l'appui de cette observation, le Tableau 2 fait état des valeurs d'indice de jaune (Yellow Index ou "YI" mesuré selon la norme ASTM E 313-05, D1925) mesurées sur des éprouvettes réalisées à partir de certaines des compositions mentionnées précédemment et mises à vieillir dans l'air à 150°C.

**Tableau 2**

| Motif | YI |
|---|---|
| 6.10 | 60 |
| 10.10 | 50 |
| 11 | 35 |

On observe donc un très faible jaunissement avec la mise en oeuvre d'un motif "11".

Dans une variante avantageuse, le polyamide semi-aromatique selon l'invention est constitué de 76 à 90% en mole du premier motif répétitif (A) et de 10 à 24% en moles du second motif répétitif (B).

Dans une variante préférée, le polyamide semi-aromatique selon l'invention est constitué de 80 à 89% en mole du premier motif répétitif (A) et de 11 à 20% en moles du second motif répétitif (B).

Le premier motif répétitif (A) du polyamide semi-aromatique selon l'invention est obtenu à partir de la polycondensation d'au moins une diamine et d'au moins un acide dicarboxylique.

La diamine utilisée pour l'obtention de ce premier motif répétitif (A) est une diamine aliphatique comprenant de 9 à 36 atomes de carbone, avantageusement de 10 à 36 atomes de carbone. Cette diamine est linéaire et répond à la formule H₂N-(CH₂)ₐ-NH₂.

Avantageusement, la diamine aliphatique est choisie parmi la nonanediamine, la décanediamine, l'undécanediamine, la dodécanediamine, la tridécanediamine, la tétradécanediamine, l'hexadécanediamine, l'octadécanedia-mine, l'octadécènediamine, l'eicosanediamine, la docosanediamine et les diamines obtenues à partir d'acides gras. Les diamines aliphatiques linéaires qui viennent d'être citées présentent toutes l'avantage d'être bioressourcées au sens de la norme ASTM D6866.

Préférentiellement, la diamine aliphatique comprend de 10 à 12 atomes de carbone et est choisie parmi la décanediamine, l'undécanediamine et la dodécanediamine.

Pour l'obtention de ce premier motif répétitif (A), on peut envisager d'utiliser une seule diamine aliphatique comprenant de 9 à 36, avantageusement de 10 à 36, atomes de carbone ou un mélange de deux, ou plus, diamines aliphatiques, toutes ces diamines aliphatiques comprenant nécessairement de 9 à 36, avantageusement de 10 à 36, atomes de carbone et étant bien entendu distinctes deux à deux.

L'acide dicarboxylique utilisé pour l'obtention de ce premier motif répétitif (A) est un acide dicarboxylique aromatique.

Cet acide dicarboxylique est avantageusement choisi parmi l'acide téréphtalique (noté T), l'acide isophtalique (noté I), les diacides naphtaléniques et leurs mélanges. Parmi les acides naphtaléniques, on peut notamment citer l'acide naphtalène-2,6-dicarboxylique.

Préférentiellement, l'acide dicarboxylique est l'acide téréphtalique (noté T).

Pour l'obtention de ce premier motif répétitif (A), on peut envisager d'utiliser un seul acide dicarboxylique aromatique ou un mélange de deux, ou plus, acides dicarboxyliques, tous ces acides dicarboxyliques étant aromatiques et bien entendu distincts deux à deux.

Le second motif répétitif (B) du polyamide semi-aromatique selon l'invention est obtenu à partir d'au moins un lactame et/ou d'au moins un acide aminocarboxylique.

Le lactame utilisé pour l'obtention de ce second motif répétitif (B) est un lactame comprenant de 9 à 12 atomes de carbone.

Avantageusement, le lactame comprend de 10 à 12 atomes de carbone et est donc choisi parmi le décanolactame, l'undécanolactame et le lauryllactame.

Préférentiellement, le lactame est le lauryllactame, qui comprend 12 atomes de carbone.

Pour l'obtention de ce premier motif répétitif (B), on peut envisager d'utiliser un seul lactame comprenant de 9 à 12 atomes de carbone ou un mélange de deux, ou plus, lactames, tous ces lactames comprenant nécessairement de 9 à 12 atomes de carbone et étant bien entendu distincts deux à deux.

L'acide aminocarboxylique utilisé pour l'obtention de ce second motif répétitif (B) est un acide aminocarboxylique comprenant de 9 à 12 atomes de carbone, de préférence un acide aminocarboxylique linéaire non ramifié. Il peut ainsi être choisi parmi l'acide 9-aminononanoïque, l'acide 10-aminodécanoïque, l'acide 10-aminoundécanoïque, l'acide 11-aminoundécanoïque et l'acide 12-aminododécanoïque.

Avantageusement, cet acide aminocarboxylique comprend de 10 à 12 atomes de carbone.

Préférentiellement, l'acide aminocarboxylique est l'acide 11-aminoundécanoïque qui comprend 11 atomes de carbone et qui présente en outre l'avantage d'être bioressourcé au sens de la norme ASTM D6866.

Pour l'obtention de ce premier motif répétitif (B), on peut envisager d'utiliser un seul acide aminocarboxylique comprenant de 9 à 12 atomes de carbone ou un mélange de deux, ou plus, acides aminocarboxyliques, tous ces acides aminocarboxyliques comprenant nécessairement de 9 à 12 atomes de carbone et étant bien entendu distincts deux à deux.

Pour l'obtention de ce premier motif répétitif (B), on peut par ailleurs envisager d'utiliser un mélange d'un ou de plusieurs lactames avec un ou plusieurs acides aminocarboxyliques, tous ces lactames et acides aminocarboxyliques comprenant chacun de 9 à 12 atomes de carbone et étant bien entendu distincts deux à deux.

Selon un deuxième aspect de l'invention, l'invention porte sur polyamide semi-aromatique constitué des premier et second motifs répétitifs (A) et (B), avec les caractéristiques particulières suivantes :
- le premier motif répétitif (A) étant obtenu à partir de la polycondensation d'une seule diamine aliphatique linéaire comprenant de 9 à 36, avantageusement de 10 à 36, atomes de carbone et d'un seul acide dicarboxylique aromatique.
   Avantageusement, la diamine aliphatique comprend de 10 à 12 atomes de carbone et l'acide dicarboxylique aromatique est l'acide téréphtalique.
- le second motif répétitif (B) étant obtenu à partir d'un seul lactame comprenant de 9 à 12 atomes de carbone ou d'un seul acide aminocarboxylique comprenant de 9 à 12 atomes de carbone. Avantageusement, le lactame est le lauryllactame et l'acide aminocarboxylique est l'acide 11-aminoundécanoïque.

Parmi les combinaisons envisageables, les polyamides semi-aromatiques suivants présentent un intérêt particulièrement marqué : il s'agit des copolyamides répondant à l'une des formules choisies parmi 10/9.T, 10/10.T, 10/11.T, 10/12.T, 11 /9.T, 11/10.T, 11/11.T, 11/12.T, 12/9.T, 12/10.T, 12/11.T et 12/12.T.

Selon un troisième aspect de l'invention, l'invention porte sur polyamide semi-aromatique constitué des premier et second motifs répétitifs (A) et (B), avec les caractéristiques particulières suivantes :
- le premier motif répétitif (A) étant obtenu à partir de la polycondensation d'une seule diamine aliphatique linéaire comprenant de 9 à 36, avantageusement de 10 à 36, atomes de carbone et d'un seul acide dicarboxylique aromatique.
   Avantageusement, la diamine aliphatique comprend de 10 à 12 atomes de carbone et l'acide dicarboxylique aromatique est l'acide téréphtalique.
   - le second motif répétitif (B) étant obtenu à partir d'au moins deux produits choisis parmi un lactame comprenant de 9 à 12 atomes de carbone et un acide aminocarboxylique comprenant de 9 à 12 atomes de carbone. Avantageusement, le lactame est le lauryllactame et l'acide aminocarboxylique est l'acide 11-aminoundécanoïque.

Parmi les combinaisons envisageables, les polyamides semi-aromatiques suivants présentent un intérêt particulièrement marqué : il s'agit des copolyamides répondant à l'une des formules choisies parmi 11/12/10.T, 11/12/11.T, 11/12/12.T.

Selon un quatrième aspect de l'invention, l'invention porte sur polyamide semi-aromatique constitué des premier et second motifs répétitifs (A) et (B), avec les caractéristiques particulières suivantes :
- le premier motif répétitif (A) étant obtenu à partir de la polycondensation d'un mélange de deux diamines aliphatiques linéaires distinctes comprenant chacune de 9 à 36, avantageusement de 10 à 36, atomes de carbone et d'un seul acide dicarboxylique aromatique. Avantageusement, les deux diamines aliphatiques comprennent chacune de 10 à 12 atomes de carbone et l'acide dicarboxylique aromatique est l'acide téréphtalique.
- le second motif répétitif (B) étant obtenu à partir d'un seul lactame comprenant de 9 à 12 atomes de carbone ou d'un seul acide aminocarboxylique comprenant de 9 à 12 atomes de carbone. Avantageusement, le lactame est le lauryllactame et l'acide aminocarboxylique est l'acide 11-aminoundécanoïque.

Parmi les combinaisons envisageables, les polyamides semi-aromatiques suivants présentent un intérêt particulièrement marqué : il s'agit des copolyamides répondant à l'une des formules choisies parmi 10/10.T/11.T, 10/10.T/12.T, 10/11.T/12.T, 11/10.T/11.T, 11/10.T/12.T, 11/11.T/12.T, 12/10.T/11.T, 12/10.T/12.T et 12/11.T/12.T.

Selon un cinquième aspect de l'invention, l'invention porte sur polyamide semi-aromatique constitué des premier et second motifs répétitifs (A) et (B), avec les caractéristiques particulières suivantes :
- le premier motif répétitif (A) étant obtenu à partir de la polycondensation d'une seule diamine aliphatique linéaire comprenant de 9 à 36, avantageusement de 10 à 36, atomes de carbone et de deux acides dicarboxyliques aromatiques distincts.
   Avantageusement, la diamine aliphatique comprend de 10 à 12 atomes de carbone et les deux acides dicarboxyliques aromatiques sont l'acide téréphtalique et l'acide isophtalique.
- le second motif répétitif (B) étant obtenu à partir d'un seul lactame comprenant de 9 à 12 atomes de carbone ou d'un seul acide aminocarboxylique comprenant de 9 à 12 atomes de carbone. Avantageusement, le lactame est le lauryllactame et l'acide aminocarboxylique est l'acide 11-aminoundécanoïque.

Parmi les combinaisons envisageables, les polyamides semi-aromatiques suivants présentent un intérêt particulièrement marqué : il s'agit des copolyamides répondant à l'une des formules choisies parmi 10/10.T/10.I, 11/9.T/9.I, 11/10.T/10.I, 11/11.T/11.I, 11/12.T/12.I, 12/9.T/9.I, 12/10.T/10.I, 12/11.T/11.I et 12/12.T/12.I.

Sans entrer plus dans les détails, la présente invention couvre également des polyamides semi-aromatiques constitués des premier et second motifs répétitifs (A) et (B), dans lesquels les caractéristiques détaillées ci-avant pour la(les) diamine(s) aliphatique(s) et le(s) acide(s) dicarboxylique(s) aromatique(s) du premier motif répétitif (A) et pour le(s) lactames et/ou acide(s) aminocarboxylique(s) du second motif répétitif (B) sont combinées les unes aux autres.

Un avantage du polyamide semi-aromatique selon l'invention est qu'il peut comporter des monomères provenant de ressources issues de matières premières renouvelables, c'est-à-dire comportant du carbone organique issu de la biomasse et déterminé selon la norme ASTM D6866. Ces monomères issus de matières premières renouvelables peuvent notamment être la 1,10-décanediamine ou encore l'acide 11-aminoundécanoïque.

L'invention porte également sur un procédé de préparation d'un polyamide semi-aromatique tel que défini ci-dessus.

Ce procédé comprend une étape de polycondensation des co-monomères conduisant au premier motif répétitif (A) et au second motif répétitif (B) constituant le polyamide semi-aromatique selon l'invention.

Cette étape de polycondensation peut être effectuée selon un procédé en continu ou en "batch".

Cette étape de polycondensation des co-monomères conduisant au premier motif répétitif (A) et au second motif répétitif (B) peut s'effectuer en présence d'agents de terminaison de chaîne et ce, dans des quantités prédéterminées en fonction du polyamide semi-aromatique particulier souhaité.

Ci-dessous sont décrits différentes variantes de procédé de préparation d'un polyamide semi-aromatique selon le deuxième aspect de l'invention, ledit polyamide étant obtenu à partir de trois co-monomères, un seul lactame, une seule diamine aliphatique (ci-après désignée "diamine") et un seul acide dicarboxylique aromatique (ci-après désigné "diacide").

Bien évidemment, ce qui va être décrit est transposable à la préparation d'un polyamide semi-aromatique selon le deuxième aspect de l'invention qui mettrait en oeuvre un acide aminocarboxylique à la place du lactame mais également à la préparation d'un polyamide semi-aromatique selon les autres aspects de l'invention envisagés ci-avant.

Selon un premier mode de mise en oeuvre du procédé selon la présente invention, ledit procédé de préparation comprend une étape unique de réaction de polycondensation entre le lactame et de la combinaison stoechiométrique de la diamine et du diacide. Cette étape peut être conduite en présence d'hypophosphite de sodium, et au moins un agent de terminaison de chaîne, d'eau et éventuellement d'autres additifs.

Selon un second mode de mise en oeuvre du procédé selon la présente invention, ledit procédé de préparation comprend deux étapes. La première étape conduit à l'obtention d'un oligomère diacide, qui va se polycondenser au cours de la seconde étape avec la diamine, selon l'enchaînement ci-dessous :
- une première étape de réaction entre la diacide avec le lactame, en présence d'un sel hypophosphite ; et
- une seconde étape de réaction de l'oligomère diacide ainsi formé à la première étape avec la diamine.

Le ou les agents de terminaison de chaînes éventuels sont introduits au cours de la première et/ou de la seconde étape.

Selon un troisième mode de mise en oeuvre du procédé selon la présente invention, ledit procédé de préparation comprend deux étapes :
- une première étape de réaction du lactame avec le diacide, et avec de 10 à 90% en poids de la diamine, en présence d'un sel hypophosphite ; et
- une seconde étape de réaction de l'oligomère produit de la première étape avec le solde de la diamine en une ou plusieurs fois.

Le ou les agents de terminaison de chaînes sont introduits au cours de la première et/ou de la seconde étape.

Selon un quatrième mode de mise en oeuvre du procédé selon la présente invention, ledit procédé de préparation comprend deux étapes :
- une première étape de réaction du lactame avec le diacide et toute la diamine, en présence d'un sel hypophosphite ; un oligomère est obtenu par vidange du réacteur sous pression de vapeur d'eau et cristallisation dudit oligomère,
- une seconde étape de post-polymérisation à pression atmosphérique ou sous vide de l'oligomère produit de la première étape.

Le ou les agents de terminaison de chaînes sont introduits au cours de la première et/ou de la seconde étape.

Ce prépolymère peut être repris directement ou avec un stockage intermédiaire sous forme solide (granulé ou poudre par exemple), afin d'effectuer la fin de la polycondensation. Cette opération est dite "remontée en viscosité". Cette remontée en viscosité peut être effectuée sur un réacteur de type extrudeuse sous pression atmosphérique ou sous vide.

Les procédés selon la présente invention peuvent être mis en oeuvre dans tout réacteur classiquement utilisé en polymérisation, tel que des réacteurs à agitateurs à ancre ou à rubans. Cependant, lorsque le procédé comporte une seconde étape telle que définie ci-dessus, il peut aussi être mis en oeuvre dans un réacteur horizontal ou finisseur, plus communément appelé par l'homme de l'art "finisher".

La présente invention se rapporte également à une composition comprenant au moins un polyamide semi-aromatique tel que défini ci-dessus.

Une composition conforme à l'invention peut comprendre en outre au moins un additif habituel des polyamides.

Parmi ces additifs, on peut notamment citer les charges, les fibres, les agents ignifugeants, les activateurs d'ignifugation, les colorants, les stabilisants (tels que stabilisants UV), les plastifiants, les modifiants chocs, les agents tensioactifs, les pigments, les azurants, les anti-oxydants, les cires naturelles et leurs mélanges.

Avantageusement, les additifs représentent jusqu'à 90%, avantageusement de 1 à 60%, de préférence de 10 à 40% et, plus préférentiellement, de l'ordre de 30% en poids par rapport au poids total de la composition.

Les charges envisagées dans le cadre de la présente invention incluent les nanocharges, telles que les nanotubes de carbone, les charges minérales classiques, telles que le kaolin, la magnésie, le talc, la wollastonite, les scories.

Parmi les fibres envisagées dans le cadre de la présente invention, on peut citer les fibres de verre et les fibres de carbone. Les fibres de verre utilisées plus généralement ont une dimension avantageusement comprise entre 0,20 et 25 mm. On peut y inclure un agent de couplage pour améliorer l'adhésion des fibres au polyamide semi-aromatique, tels que les silanes ou les titanates, qui sont connus de l'homme de l'art. Des charges anioniques peuvent également être utilisées, telles que le graphite ou les fibres aramides (polyamides entièrement aromatiques).

De préférence, les fibres de verre sont présentes dans la composition généralement en une teneur de 10 à 50%, de préférence l'ordre de 30% en poids par rapport au poids total de la composition.

Une composition conforme à l'invention peut comprendre, les pourcentages pondéraux étant exprimés par rapport au poids total de la composition :
- au moins 40% en poids du polyamide selon l'invention,
- de 10 à 60% en poids de fibres de verre,
- de 0 à 30%, de préférence de 0 à 8% en poids d'agent ignifugeant, comprenant éventuellement un activateur d'ignifugation.

Parmi les agents d'ignifugation connus, on peut citer le cyanurate de mélamine ainsi que le phosphore, ses dérivés tels que le phosphore rouge (US 3 778 407), les phosphites, les phosphates et les phosphinates. On peut également citer les agents d'ignifugation et les activateurs d'ignifugation décrits dans le document FR 2 900 409 qui sont particulièrement adaptés aux compositions à base de polyamides semi-aromatiques.

Il est précisé qu'en ajoutant des additifs phosphorés, dont certains peuvent être de surcroît des agents ignifugeants, on améliore encore la réflectance des pièces obtenues à partir de la composition selon l'invention.

Parmi les pigments susceptibles d'être introduits dans une composition conforme à l'invention, on peut citer les pigments blancs tels que le dioxyde de titane.

En effet, les pigments blancs permettent également d'améliorer la réflectance des pièces obtenues à partir de telles compositions selon l'invention. Les compositions correspondantes présentent alors un intérêt majeur pour une utilisation dans la fabrication de pièces telles que les réflecteurs LED.

De manière avantageuse, la proportion pondérale de pigments, notamment de pigments blancs, est comprise entre 10 et 40% par rapport au poids total de la composition.

Ainsi, une composition conforme à l'invention peut également comprendre, les pourcentages pondéraux étant exprimés par rapport au poids total de la composition :
- au moins 40% en poids du polyamide selon l'invention,
- de 10 à 40% en poids de pigments, tels que du dioxyde de titane,
- de 0 à 60% en poids de fibres de verre,
- de 0 à 30%, de préférence de 0 à 8% en poids d'agent ignifugeant, comprenant éventuellement un activateur d'ignifugation.

Une composition conforme à l'invention peut également comprendre en outre au moins un deuxième polymère.

Avantageusement, ce deuxième polymère peut être choisi parmi un polyamide semi-cristallin, un polyamide amorphe, un copolyamide semi-cristallin, un copolyamide amorphe, un polyétheramide, un polyesteramide, un polyester aromatique, un arylamide et leurs mélanges.

Ce deuxième polymère peut également être choisi parmi l'amidon, qui peut être modifié et/ou formulé, la cellulose ou ses dérivés comme l'acétate de cellulose ou les éthers de cellulose, le polyacide lactique, le polyacide glycolique et les polyhydroxyalcanoate.

En particulier, ce deuxième polymère peut être une ou plusieurs polyoléfines fonctionnelles ou non fonctionnelles, réticulées ou non.

Les compositions comprenant un polyamide semi-aromatique selon l'invention peuvent être préparées par toute méthode qui rend possible l'obtention d'un mélange homogène, telle que l'extrusion à l'état fondu, le compactage ou encore le malaxeur à rouleau.

Plus particulièrement, la composition selon l'invention est préparée par mélange à l'état fondu de tous les ingrédients dans un procédé dit en direct.

Avantageusement, la composition peut être obtenue sous forme de granulés par compoundage sur un outil connu de l'homme de l'art tel que extrudeuse bivis, comalaxeur ou mélangeur interne.

La composition selon l'invention obtenue par le procédé de préparation décrit ci-dessus peut être ensuite transformée pour une utilisation ou une transformation ultérieure connue par l'homme de l'art à l'aide d'outils tels que presse à injecter ou encore extrudeuse.

L'invention porte ainsi aussi sur un article obtenu par injection, extrusion, extrusion-soufflage, coextrusion, multi-injection à partir d'au moins une composition telle que définie ci-dessus.

Le procédé de préparation de la composition selon l'invention peut aussi utiliser une extrudeuse bi-vis alimentant, sans granulation intermédiaire, une presse à injecter ou une extrudeuse selon un dispositif de mise en oeuvre connu par l'homme de l'art.

La présente invention concerne également l'utilisation d'un polyamide semi-aromatique tel que décrit ci-dessus ou d'une composition telle que décrite ci-dessus pour constituer une poudre, des granulés, une structure monocouche ou au moins une couche d'une structure multicouche.

Le polyamide semi-aromatique tel que décrit ci-dessus ou la composition telle que décrite ci-dessus comprenant un tel polyamide peut être utilisé(e) l'obtention de pièces.

Parmi ces pièces, on citera tout particulièrement les pièces injectées telles que des connecteurs, des commutateurs, des réflecteurs à diode électroluminescente (LED), des supports de composants électriques et électroniques, de telles pièces pouvant être destinées au domaine industriel en général, et à l'industrie électrique et électronique en particulier.

De telles pièces peuvent tout particulièrement être obtenues par la technologie SMT à partir du polyamide semi-aromatique ou de la composition selon l'invention. Ce polyamide semi-aromatique ou cette composition peut en particulier être utilisé(e) comme composition de brasage.

De telles pièces, qu'elles soient électroniques ou non, peuvent de manière générale également être utilisées dans le transport de fluides, dans le domaine automobile, notamment des pièces disposées dans le moteur ou sous capot-moteur, et dans le domaine industriel en général.

## Revendications

1. Polyamide semi-aromatique constitué :
- de 70 à 95% en moles d'un premier motif répétitif (A) obtenu à partir de la polycondensation d'au moins une diamine aliphatique linéaire comprenant de 10 à 36 atomes de carbone et d'au moins un acide dicarboxylique aromatique, et
- de 5 à 30% en moles d'un second motif répétitif (B) obtenu à partir d'au moins un lactame comprenant de 9 à 12 atomes de carbone et/ou d'au moins un acide aminocarboxylique comprenant de 9 à 12 atomes de carbone.

2. Polyamide semi-aromatique selon la revendication 1, **caractérisé en ce qu'**il est constitué de 76 à 90% en mole du premier motif répétitif (A) et de 10 à 24% en moles du second motif répétitif (B).

3. Polyamide semi-aromatique selon la revendication 1 ou 2, **caractérisé en ce qu'**il est constitué de 80 à 89% en mole du premier motif répétitif (A) et de 11 à 20% en moles du second motif répétitif (B).

4. Polyamide semi-aromatique selon l'une quelconque des revendications 1 à 3, **caractérisé en ce que** la diamine aliphatique linéaire comprend de 10 à 12 atomes de carbone.

5. Polyamide semi-aromatique selon l'une quelconque des revendications 1 à 4, **caractérisé en ce que** l'acide dicarboxylique aromatique est choisi parmi l'acide téréphtalique (noté T), l'acide isophtalique (noté I), les acides naphtaléniques et leurs mélanges.

6. Polyamide semi-aromatique selon la revendication 5, **caractérisé en ce que** l'acide dicarboxylique aromatique est l'acide téréphtalique (noté T).

7. Polyamide semi-aromatique selon l'une quelconque des revendications 1 à 6, **caractérisé en ce que** le lactame comprend de 10 à 12 atomes de carbones, préférentiellement 12 atomes de carbone.

8. Polyamide semi-aromatique selon l'une quelconque des revendications 1 à 7, **caractérisé en ce que** l'acide aminocarboxylique comprend de 10 à 12 atomes de carbones, préférentiellement 11 atomes de carbone.

9. Polyamide semi-aromatique selon l'une quelconque des revendications 1 à 8, **caractérisé en ce qu'**il répond à l'une des formules suivantes : 10/10.T, 11/10.T, 12/10.T, 10/11.T, 11/11.T, 12/11.T, 10/12.T. 11/12.T, 12/12.T, 10/10.T/11.T, 11/10.T/12.T, 12/10.T/12.T, 10/10.T/10.I, 11/10.T/10.I et 12/10.T/10.I.

10. Procédé de préparation du polyamide semi-aromatique selon l'une quelconque des revendications 1 à 9, **caractérisé en ce qu'**il comprend une étape de polycondensation des co-monomères conduisant au premier motif répétitif (A) et au second motif répétitif (B).

11. Composition comprenant au moins un polyamide semi-aromatique selon l'une quelconque des revendications 1 à 9.

12. Composition selon la revendication 11, **caractérisée en ce qu'**elle comprend en outre au moins un additif choisi parmi les charges, les fibres (de carbone et/ou de verre), les agents ignifugeants, les activateurs d'ignifugation, les colorants, les stabilisants, les plastifiants, les modifiants chocs, les agents tensioactifs, les pigments, les azurants, les anti-oxydants, les cires naturelles et leurs mélanges.

13. Utilisation d'un polyamide semi-aromatique tel que défini à l'une quelconque des revendications 1 à 9 ou d'une composition telle que définie à la revendication 11 ou 12 pour constituer tout ou partie d'une pièce électronique, destinée notamment à l'industrie électrique ou électronique.

14. Utilisation selon la revendication 13, **caractérisée en ce que** la pièce électronique est un connecteur, un commutateur ou un réflecteur à diode électroluminescente (Light Emitting Diode ou LED).

15. Utilisation selon la revendication 13 ou 14 pour la mise en oeuvre de la technologie dite des éléments installés en surface (SMT).

## Patentansprüche

1. Halbaromatisches Polyamid, bestehend aus:
- 70 bis 95 Mol-% einer ersten Wiederholungseinheit (A), die aus der Polykondensation mindestens eines aliphatischen, linearen Diamins, umfassend 10 bis 36 Kohlenstoffatome, und mindestens einer aromatischen Dicarbonsäure erhalten wird, und
- 5 bis 30 Mol-% einer zweiten Wiederholungseinheit (B), die aus mindestens einem Lactam, umfassend 9 bis 12 Kohlenstoffatome, und/oder mindestens einer Aminocarbonsäure, umfassend 9 bis 12 Kohlenstoffatome, erhalten wurde.

2. Halbaromatisches Polyamid nach Anspruch 1, **dadurch gekennzeichnet, dass** es aus 76 bis 90 Mol-% der ersten Wiederholungseinheit (A) und 10 bis 24 Mol-% der zweiten Wiederholungseinheit (B) besteht.

3. Halbaromatisches Polyamid nach Anspruch 1 oder 2, **dadurch gekennzeichnet, dass** es aus 80 bis 89 Mol-% der ersten Wiederholungseinheit (A) und 11 bis 20 Mol-% der zweiten Wiederholungseinheit (B) besteht.

4. Halbaromatisches Polyamid nach einem der Ansprüche 1 bis 3, **dadurch gekennzeichnet, dass** das aliphatische, lineare Diamin 10 bis 12 Kohlenstoffatome umfasst.

5. Halbaromatisches Polyamid nach einem der Ansprüche 1 bis 4, **dadurch gekennzeichnet, dass** die aromatische Dicarbonsäure aus Terephtalsäure (mit T bezeichnet), Isophtalsäure (mit I bezeichnet), Naphtalsäuren und deren Gemischen ausgewählt ist.

6. Halbaromatisches Polyamid nach Anspruch 5, **dadurch gekennzeichnet, dass** die aromatische Dicarbonsäure Terephtalsäure (mit T bezeichnet) ist.

7. Halbaromatisches Polyamid nach einem der Ansprüche 1 bis 6, **dadurch gekennzeichnet, dass** das Lactam 10 bis 12 Kohlenstoffatome, bevorzugt 12 Kohlenstoffatome umfasst.

8. Halbaromatisches Polyamid nach einem der Ansprüche 1 bis 7, **dadurch gekennzeichnet, dass** die Aminocarbonsäure 10 bis 12 Kohlenstoffatome, bevorzugt 11 Kohlenstoffatome umfasst.

9. Halbaromatisches Polyamid nach einem der Ansprüche 1 bis 8, **dadurch gekennzeichnet, dass** es einer der folgenden Formeln entspricht: 10/10.T, 11/10.T, 12/10.T, 10/11.T, 11/11.T, 12/11.T, 10/12.T, 11/12.T, 12/12.T, 10/10.T/11.T, 11/10.T/12.T, 12/10.T/12.T, 10/10.T/10.I, 11/10.T/10.I und 12/10.T/10.I.

10. Verfahren zur Herstellung des halbaromatischen Polyamids nach einem der Ansprüche 1 bis 9, **dadurch gekennzeichnet, dass** es einen Schritt zur Polykondensation der Co-Monomere umfasst, der zur ersten Wiederholungseinheit (A) und zur zweiten Wiederholungseinheit (B) führt.

11. Zusammensetzung, umfassend mindestens ein halbaromatisches Polyamid nach einem der Ansprüche 1 bis 9.

12. Zusammensetzung nach Anspruch 11, **dadurch gekennzeichnet, dass** sie ferner mindestens einen Zusatzstoff umfasst, der aus Füllstoffen, (Kohlenstoff-und/oder aus Glas-) Fasern, Flammhemmern, Flammschutzmittel-Aktivatoren, Farbstoffen, Stabilisatoren, Weichmachern, Schlagzähigkeitsver-besserern, Tensiden, Pigmenten, Aufhellern, Antioxidationsmitteln, natürlichen Wachsen und deren Gemischen ausgewählt ist.

13. Verwendung eines halbaromatischen Polyamids, wie in einem der Ansprüche 1 bis 9 definiert, oder einer Zusammensetzung, wie in Anspruch 11 oder 12 definiert, um die Gesamtheit oder einen Teil eines elektronischen Bauteils zu bilden, das insbesondere für die elektrische oder elektronische Industrie bestimmt ist.

14. Verwendung nach Anspruch 13, **dadurch gekennzeichnet, dass** das elektronische Bauteil ein Konnektor, ein Umschalter oder ein Leuchtdiodenreflektor (Light Emitting Diode oder LED) ist.

15. Verwendung nach Anspruch 13 oder 14 zum Einsatz in der SMT-Technologie.

## Claims

1. Semiaromatic polyamide consisting:
- of 70 to 95 mol% of a first repeating unit (A) obtained from the polycondensation of at least one linear aliphatic diamine comprising from 10 to 36 carbon atoms and of at least one aromatic dicarboxylic acid; and
- of 5 to 30 mol% of a second repeating unit (B) obtained from at least one lactam comprising from 9 to 12 carbon atoms and/or from at least one aminocarboxylic acid comprising from 9 to 12 carbon atoms.

2. Semiaromatic polyamide according to Claim 1, **characterized in that** it consists of 76 to 90 mol% of the first repeating unit (A) and of 10 to 24 mol% of the second repeating unit (B).

3. Semiaromatic polyamide according to Claim 1 or 2, **characterized in that** it consists of 80 to 89 mol% of the first repeating unit (A) and of 11 to 20 mol% of the second repeating unit (B).

4. Semiaromatic polyamide according to any one of Claims 1 to 3, **characterized in that** the linear aliphatic diamine comprises from 10 to 12 carbon atoms.

5. Semiaromatic polyamide according to any one of Claims 1 to 4, **characterized in that** the aromatic dicarboxylic acid is chosen from terephthalic acid (denoted by T), isophthalic acid (denoted by I), naphthalenic acids and mixtures thereof.

6. Semiaromatic polyamide according to Claim 5, **characterized in that** the aromatic dicarboxylic acid is terephthalic acid (denoted by T).

7. Semiaromatic polyamide according to any one of Claims 1 to 6, **characterized in that** the lactam comprises from 10 to 12 carbon atoms, preferably 12 carbon atoms.

8. Semiaromatic polyamide according to any one of Claims 1 to 7, **characterized in that** the aminocarboxylic acid comprises from 10 to 12 carbon atoms, preferably 11 carbon atoms.

9. Semiaromatic polyamide according to any one of Claims 1 to 8, **characterized in that** it corresponds to one of the following formulae: 10/10,T, 11/10,T, 12/10,T, 10/11,T, 11/11,T, 12/11,T, 10/12,T, 11/12,T, 12/12,T, 10/10,T/11,T, 11/10,T/12,T, 12/10,T/12,T, 10/10,T/10,I, 11/10,T/10,I and 12/10,T/10,I.

10. Process for preparing the semiaromatic polyamide according to any one of Claims 1 to 9, **characterized in that** it comprises a step of polycondensation of the comonomers leading to the first repeating unit (A) and to the second repeating unit (B).

11. Composition comprising at least one semiaromatic polyamide according to any one of Claims 1 to 9.

12. Composition according to Claim 11, **characterized in that** it comprises, in addition, at least one additive chosen from fillers, fibres (carbon and/or glass fibres), flame retardants, flame retardant synergists, dyes, stabilizers, plasticizers, impact modifiers, surfactants, pigments, brighteners, antioxidants, natural waxes and mixtures thereof.

13. Use of a semiaromatic polyamide as defined in any one of Claims 1 to 9 or of a composition as defined in Claim 11 or 12 for constituting all or part of an electronic part, intended in particular for the electrical or electronics industry.

14. Use according to Claim 13, **characterized in that** the electronic part is a light-emitting diode (or LED) reflector, switch or connector.

15. Use according to Claim 13 or 14 for the implementation of surface-mount technology (SMT).
